# DEMANDE DE BREVET EUROPEEN

(11) **EP 2 657 364 A1**
(43) Date de publication de la demande: **30.10.2013**
(21) Numéro de dépôt: 13164712.5
(22) Date de dépôt: 22.04.2013
(51) Int. Cl.: C23C 16/44, C23C 16/455, H01L 51/56, H01L 51/52, C23C 16/40

(54) **Réacteur pour le dépôt de couche atomique (ALD), pour l'encapsulation d'un dispositif OLED par dépôt de couche transparente en Al2o3**

(30) Priorité: 24.04.2012 FR 1253729
(71) Demandeur: COMMISSARIAT A L'ENERGIE ATOMIQUE ET AUX ENERGIES ALTERNATIVES, 75015 Paris (FR)
(72) Inventeur: Maindron, Tony, 38000 Grenoble (FR)
(74) Mandataire: Nony

(57) **Abrégé**

La présente invention concerne un réacteur (1) pour le dépôt de couche atomique (ALD) comprenant :
- une chambre de réaction (10) comprenant une sole (100) et délimitée intérieurement par des surfaces,
- au moins un orifice d'entrée (11) et au moins un orifice de sortie (12) débouchant chacun dans une des surfaces de délimitation;

Il comprend en outre en son sein, au moins une paroi ouverte en au moins un orifice, la paroi ouverte s'étendant autour de la sole et sur au moins une majeure partie de la hauteur entre la surface inférieure et la surface supérieure, au moins un orifice d'au moins une des parois ouvertes n'étant pas en regard de l'orifice d'entrée de sorte à former des chicanes de circulation de précurseur gazeux depuis chaque orifice d'entrée (11) jusqu'à la sole (100).

## Description

### Domaine technique

La présente invention concerne un nouveau type de réacteur utilisé pour le dépôt de couche atomique (acronyme anglais ALD pour « *Atomic Layer Deposition* »).

La présente invention a trait plus particulièrement à une nouvelle architecture d'un tel réacteur qui permet de réduire considérablement la densité de particules présentes dans la chambre de réaction du réacteur.

L'invention s'applique avantageusement à l'encapsulation d'un dispositif à diodes électroluminescentes organiques (acronymes anglais OLED pour « *Organic Light-Emitting Diode* ») par dépôt d'une couche d'encapsulation transparente, telle qu'une couche en Al₂O₃.

### Etat de la technique

Actuellement, il est nécessaire de réaliser une encapsulation de dispositifs à OLED afin d'assurer la protection de leurs composants sensibles aux espèces gazeuses de l'atmosphère (oxygène et vapeur d'eau essentiellement). En effet, si la protection n'est pas convenablement réalisée, il subsiste un risque de dégradation ultérieure du dispositif qui se traduit essentiellement par l'apparition de points noirs non émissifs. Ces points noirs résultent en fait de la pénétration de la vapeur d'eau dans la diode, ce qui dégrade l'interface entre cathode ou anode et film(s) organique(s).

Pour des raisons de coût et pour certaines applications, deux types de technique de dépôt chimique en phase vapeur sont à ce jour principalement mis en oeuvre pour réaliser le dépôt de couches minces sur un dispositif OLED. Ces couches minces doivent avoir un effet de barrière en protégeant le dispositif de l'agression de l'humidité extérieure. De manière générale, ces couches minces à effet de barrière sont des oxydes, des nitrures ou des oxynitrures ou le cas échéant des couches minces métalliques, ces dernières ne pouvant pas être utilisées lorsque le ou les OLED émet(tent) par le sommet du dispositif auquel cas les couches barrières doivent nécessairement être transparentes.

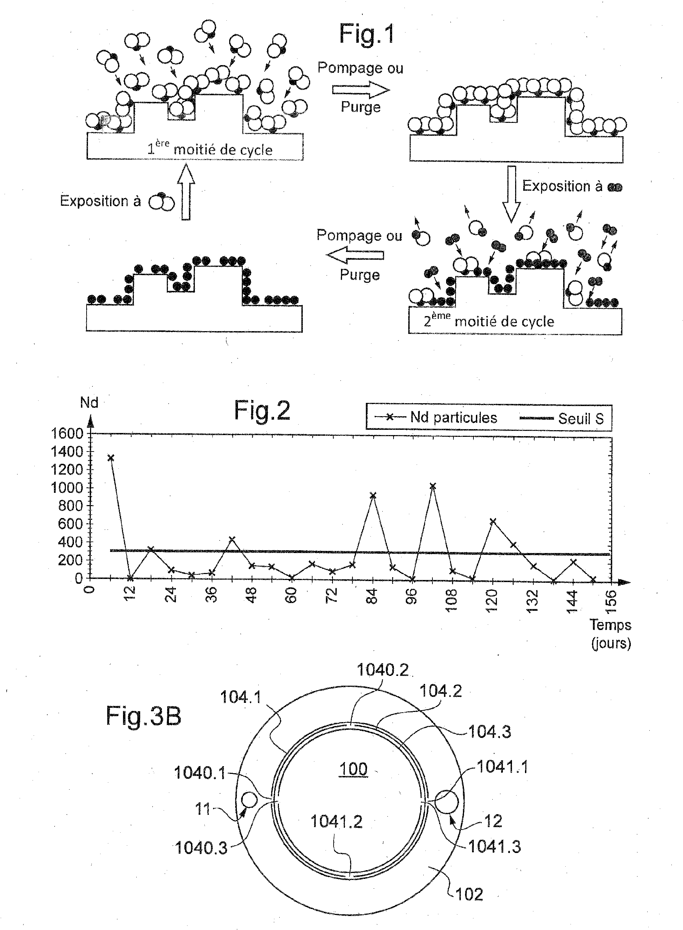

Le premier type concerne la technique de dépôt dite PECVD (acronyme anglais pour « *Plasma Enhanced Chemical Vaporisation Deposition* »), selon laquelle les réactifs gazeux, aussi appelés précurseurs gazeux, sont introduits simultanément et réagissent en phase vapeur (nucléation en phase gazeuse), ainsi qu'avec la surface du substrat, ce qui crée certains agrégats. Ces agrégats sont néfastes car ils sont susceptibles d'ajouter une contamination du substrat par des particules et également une plus grande rugosité de la couche mince [1], [2]. Le deuxième type concerne la technique ALD (acronyme anglais pour « *Atomic Layer Deposition* »), selon laquelle les réactifs (précurseurs) sont introduits alternativement et ces phases d'introduction des réactifs sont séparées par des phases de purge avec un gaz inerte, tel que le diazote N₂. La réaction d'adsorption entre un précurseur et le substrat se fait dans une seconde phase. Le principe d'un cycle de dépôt ALD est illustré schématiquement en figure 1. La réaction est dite auto-saturante car le précurseur ne réagit pas avec lui-même en phase gazeuse. Les précurseurs étant injectés alternativement, les réactions en phase gazeuse entre les précurseurs sont inhibées, ce qui limite la formation d'agrégats et empêche la formation de défauts dans les films minces, ces défauts étant usuellement appelés trous d'épingles (en anglais « *pinholes* »). Si l'on suppose que ce phénomène d'inhibition est renforcé lors de dépôts réalisés à basse température, il s'avère que la technique ALD est de loin la technologie la plus adaptée pour l'encapsulation de dispositifs organiques dans le sens où, intrinsèquement, elle créée peu de contamination particulaire en comparaison de la technique PECVD, et en outre elle permet de réaliser des dépôts totalement conformes.

Néanmoins, l'inventeur a constaté qu'il se crée toujours des particules et que, de fait, il existe une densité de particules résiduelles dans les réacteurs mettant en oeuvre la technique ALD. Sur le graphique illustré en figure 2, on a représenté le test de contamination particulaire en fonction du temps tel que mesuré par l'inventeur en salle blanche sur un réacteur ALD utilisé pour le dépôt d'une couche d'encapsulation Al₂O₃ sur un substrat à OLED. Plus exactement, le réacteur est celui commercialisé par la société Cambridge NanoTech sous la dénomination commerciale Savannah. L'appareil de mesure est le détecteur de défaut de surface commercialisé par la société Kla-Tencor Corporation, Tencor Instruments sous la marque Surfscan®. De ce graphique, on constate que la présence de particules est inévitable. Actuellement, dans la pratique, on s'efforce donc de maintenir une densité faible, c'est-à-dire en dessous d'un seuil S de nombre de particules par cm² (Nd) fixé au préalable : typiquement S est choisi inférieur à 300/cm² comme illustré en figure 2. Un tel seuil doit être fixé car, comme déjà indiqué ci-dessus, les particules sont gênantes lorsque l'on désire déposer des films d'oxydes à effet barrière sans défaut. Les pics de densité de particules montrés en figure 2 correspondent donc à des périodes de fonctionnement du réacteur ALD immédiatement avant sa maintenance: de fait, la création chaotique de particules après un nombre de cycle important dans le réacteur est incontournable à cause du délaminage des dépôts réalisé à partir des parois délimitant la chambre de réaction lorsque les épaisseurs desdits dépôts sont trop importantes. Ainsi, la maintenance totale et régulière d'un réacteur ALD s'avère nécessaire. Cette maintenance est conséquente et coûteuse, car elle nécessite un nettoyage complet de la machine qui intègre le réacteur notamment par des opérations de sablage et d'attaque chimique.

Le but général de l'invention est de pallier au moins une partie des inconvénients de l'état de l'art et donc de proposer une solution qui permette d'éviter à tout le moins réduire, dans un réacteur, la densité de particules résiduelles susceptibles d'atteindre un substrat sur lequel on souhaite réaliser un dépôt de couche atomique ALD.

### Exposé de l'invention

Pour ce faire, l'invention a pour objet un réacteur pour le dépôt de couche atomique (ALD) comprenant :
- une chambre de réaction comprenant une sole adaptée pour supporter un substrat et étant délimitée intérieurement par une surface supérieure, une surface inférieure et une surface latérale entre la surface inférieure et la surface supérieure,
- au moins un orifice d'entrée débouchant dans une des surfaces de délimitation de la chambre, et par lequel au moins un précurseur gazeux peut être injecté directement dans la chambre de réaction;
- au moins un orifice de sortie débouchant dans une des surfaces de délimitation de la chambre, et par lequel des espèces gazeuses ou des particules présentes dans la chambre de réaction peuvent être évacuées.

Selon l'invention, la chambre de réaction comprend en outre en son sein, au moins une paroi ouverte en au moins un orifice, la paroi ouverte s'étendant autour de la sole et sur au moins la moitié de la hauteur entre la surface inférieure et la surface supérieure, au moins un orifice d'au moins une des parois ouvertes n'étant pas en regard de l'orifice d'entrée de sorte à former des chicanes de circulation de précurseur gazeux depuis chaque orifice d'entrée jusqu'à la sole.

Par « un orifice d'au moins une des parois ouvertes n'étant pas en regard de l'orifice d'entrée», on entend que si on considère l'espace (portion de camembert) dont les parois sont issues du centre de la sole et tangentes à l'orifice d'entrée, l'ouverture de la paroi ne se situe pas dans cet espace.

Selon un mode de réalisation avantageux, la chambre de réaction peut comprendre en son sein, une pluralité de parois ouvertes chacune en au moins un orifice, la pluralité de parois ouvertes s'étendant autour de la sole et sur au moins une majeure partie de la hauteur entre la surface inférieure et la surface supérieure, un orifice d'une paroi ouverte n'étant pas en regard d'un orifice d'une paroi ouverte adjacente de sorte à former de chicanes de circulation de précurseur gazeux depuis chaque orifice d'entrée jusqu'à la sole.

Par « sole », on comprend la partie de la chambre de réaction dédiée au positionnement / supportage du substrat sur lequel on souhaite réaliser le dépôt d'une couche atomique.

Par « majeure partie de la hauteur », on comprend une dimension supérieure à au moins 50% de la distance séparant les surfaces inférieure et supérieure selon l'axe longitudinal de la chambre, c'est-à-dire dans le sens de sa hauteur et avantageusement au moins 75 voire 90%. Il va de soi que la hauteur d'une paroi ouverte selon l'invention peut avoir une hauteur égale à 100% de la distance séparant les surfaces inférieure et supérieure. La hauteur d'une paroi ouverte peut être moindre et on peut alors avantageusement prévoir un joint d'étanchéité dont la hauteur vient s'ajouter pour atteindre la hauteur de chambre. Ainsi, lorsque la surface supérieure de la chambre de réaction est amovible en formant un couvercle, on peut prévoir un joint d'étanchéité solidaire du couvercle qui vient s'aligner avec les parois ouvertes lors de la fermeture de la chambre par le positionnement du couvercle. Lorsque la hauteur d'une paroi ouverte n'est pas égale à 100% de la hauteur de chambre, on veille à ce que l'orifice de la paroi ouverte soit éloigné de l'orifice d'entrée. Ainsi, par exemple, si l'orifice d'entrée est réalisé sur la surface inférieure ou sur le bas de la surface latérale de la chambre de réaction, l'orifice de la paroi est de préférence réalisé du côté supérieur de la paroi et réciproquement.

Une paroi ouverte selon l'invention peut être réalisée avantageusement en aluminium ou en acier inoxydable (inox). Dans l'ensemble de la demande, les termes « entrée » et « sortie » sont utilisés par référence respectivement avec l'injection dans la chambre de réaction des précurseurs (réactifs) gazeux utilisés pour le dépôt de couche atomique ALD et avec le pompage (aspiration) des précurseurs gazeux non adsorbés par le substrat et/ou les particules présentes dans la chambre de réaction.

Il peut y avoir une pluralité d'orifices d'entrée et de sortie répartis sur tout ou partie du pourtour de la chambre.

Les termes « supérieure», «inférieure», « latérale » sont utilisés par référence avec la configuration installée en position horizontale de la chambre de réaction, c'est-à-dire avec une sole à l'horizontal.

Selon un mode de réalisation avantageux, l'orifice d'entrée et l'orifice de sortie sont formés dans la surface inférieure et disposés de part et d'autre du centre de la sole .On choisit dans ce cas de localiser avantageusement l'ouverture de la paroi la plus proche de (des) orifice(s) d'entrée sensiblement perpendiculairement (à +/- 15°) à l'axe reliant l'orifice d'entrée et l'orifice de sortie.

Selon un mode de réalisation préféré, les parois sont de forme générale cylindrique et sont agencées autour de la sole de manière concentrique l'une par rapport à l'autre.

Avantageusement, chaque paroi ouverte est percée de deux orifices diamétralement opposés, chaque orifice d'une paroi étant agencé angulairement à 90° d'un orifice d'une paroi ouverte adjacente par rapport à l'axe des cylindres.

Selon une variante, le(s) orifice(s) de la (des) paroi(s) ouverte(s) est (sont) un (des) trou(s) de section circulaire. Les orifices peuvent également être réalisés sous forme de fente, de préférence allongée dans le sens de la hauteur des parois ouvertes, c'est-à-dire des fentes allongées de la surface inférieure vers la surface supérieure. Ces fentes peuvent par exemple avoir une largeur inférieure à 1 cm, de préférence entre 3 et 7 mm, voire avantageusement inférieure à 5 mm, de préférence encore entre 3 et 5 mm.

Selon un mode de réalisation avantageux, la paroi ouverte la plus proche des orifices d'entrée et de sortie est ouverte en deux orifices dont l'un est agencé à proximité de l'orifice d'entrée et l'autre est agencé à proximité de l'orifice de sortie.

L'invention a également pour objet un procédé de réalisation d'une couche mince sur un substrat par dépôt de couche atomique (ALD), selon lequel on réalise les étapes suivantes :
a/ positionnement du substrat sur la sole d'une chambre de réaction délimitée intérieurement par une surface supérieure, une surface inférieure et une surface latérale entre la surface inférieure et la surface supérieure, ladite chambre comprenant en outre en son sein, au moins une paroi ouverte en au moins un orifice, au moins une paroi ouverte s'étendant autour de la sole et sur au moins une majeure partie de la hauteur entre la surface inférieure et la surface supérieure, au moins un orifice d'au moins une des parois ouvertes n'étant pas en regard de l'orifice d'entrée;
b/ obturation de l'orifice de sortie débouchant dans une des surfaces de délimitation de la chambre, et par lequel des espèces gazeuses ou des particules présentes dans la chambre de réaction peuvent être évacuées;
c/ injection d'un premier précurseur gazeux de la couche mince à travers un orifice d'entrée débouchant dans une des surfaces de délimitation de la chambre tout en maintenant l'orifice de sortie obturé pendant une première durée;
d/ arrêt de l'injection et ouverture de l'orifice de sortie avec aspiration à travers celui-ci; les étapes b/ à d/ étant réitérées mais avec un deuxième précurseur de la couche mince pendant une deuxième durée.

Avantageusement, le positionnement du substrat selon l'étape a/ est réalisé en orientant vers le bas sa surface sur laquelle la couche mince est réalisée. On peut ainsi réduire encore à la surface du substrat les particules émanant du couvercle.

Selon une variante, les premier et deuxième précurseurs gazeux sont injectés par le même orifice d'entrée.

Le procédé de l'invention peut être avantageusement être mise en oeuvre pour la réalisation d'une couche mince d'Al₂O₃ sur un substrat par dépôt de couche atomique (ALD) tel que décrit précédemment avec le premier précurseur constitué par le triméthylaluminium (TMA) et le deuxième précurseur constitué par de la vapeur d'eau.

L'invention concerne enfin l'application du procédé qui vient d'être décrit pour l'encapsulation de dispositif à diodes électroluminescentes organiques (OLED). En particulier, la couche d'encapsulation de dispositif OLED peut être avantageusement constituée par une couche en Al₂O₃ transparente et parfaitement conforme au substrat.

Ainsi, selon l'invention, les chicanes de circulation des précurseurs gazeux empêchent les particules résiduelles d'atteindre directement la surface du substrat sur lequel on souhaite réaliser le dépôt de couche mince. Autrement dit, les chicanes forment en quelque sorte un obstacle définissant un chemin tortueux pour les précurseurs gazeux et modifient ainsi leur parcours par rapport à une architecture selon l'état de l'art dans laquelle les précurseurs gazeux s'écoulent en permanence par pompage transversalement et directement sur le substrat depuis l'orifice d'entrée vers l'orifice de sortie lors du cycle de dépôt. Autrement dit encore, le chemin tortueux des précurseurs gazeux créé par les chicanes permet notamment aux particules de ne pas être projetées directement à la surface du substrat. On évite ou tout du moins on réduit considérablement la contamination particulaire des substrats.

Pour éviter une quelconque inhomogénéité de dépôt de la couche mince à la surface du substrat, on prévoit selon le procédé de l'invention d'obturer l'orifice de sortie, préalablement à l'injection d'un précurseur gazeux. Grâce à cela, toute la chambre de réaction est exposée aux précurseurs gazeux mais sans que le flux de dépôt ne soit perturbé car il n'y a pas d'écoulement à proprement parler du fait de l'obturation de l'orifice de sortie. On s'assure donc d'exposer la surface totale de la chambre et de la surface apparente du substrat aux précurseurs réactifs. En d'autres termes, on crée à coup sûr une diffusion des précurseurs gazeux dans toutes les aspérités du substrat sans que celui-ci ne soit contaminé par les particules.

### Description détaillée

D'autres avantages et caractéristiques de l'invention ressortiront mieux à la lecture de la description détaillée de l'invention faite à titre illustratif et non limitatif en référence aux figures suivantes parmi lesquelles :
- la figure 1 est une vue schématique du principe d'un cycle de réaction selon la technique ALD;
- la figure 2 est un graphique de relevé de densité de particules en nombre par cm² en fonction du temps dans un réacteur mettant en oeuvre la technique ALD selon l'état de l'art ;
- la figure 3A est une vue en perspective d'un mode de réalisation d'une chambre de réaction d'un réacteur ALD selon l'invention ;
- la figure 3B est une vue de dessus du réacteur ALD selon l'invention.

Les figures 1 et 2 ont déjà été commentées en préambule. Elles ne sont donc pas décrites ici plus en détail.

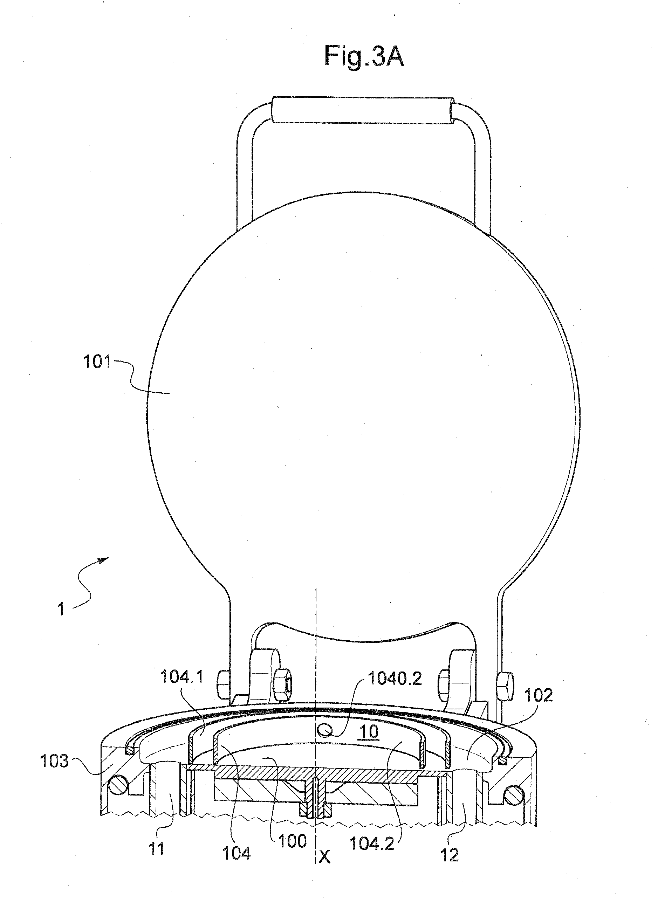

On a représenté en figures 3A et 3B, un réacteur ALD selon l'invention 1. On précise que par souci de clarté, on a représenté seulement deux parois ouvertes 104.1, 104.2 selon l'invention en figure 3A.

Le réacteur ALD selon l'invention 1 comprend une chambre de réaction 10 de forme générale cylindrique autour de son axe longitudinal X elle-même comprenant une sole 100 et délimitée par un couvercle 101 qui constitue la surface supérieure, une base 102 qui forme la surface inférieure et une paroi latérale 103 de forme générale annulaire. Comme représenté en position ouverte en figure 3A, le couvercle 101 s'ouvre par pivotement autour d'un axe horizontal et permet ainsi le positionnement direct sur la sole 100 d'un substrat (non représenté) sur lequel on souhaite effectuer un dépôt ALD.

La base 102 est percée d'un seul orifice d'entrée 11.

Pour éviter à tout le moins réduire la contamination particulaire du substrat, on prévoit selon l'invention une pluralité de parois cylindriques 104.1, 104.2, 104.3 ouvertes en deux orifices respectivement 1040.1, 1041.1 ; 1040.2, 1041.2 ; 1040.3, 1041.3, et agencées concentriquement l'une par rapport à l'autre autour de la sole 100 avec un orifice d'une paroi ouverte non en regard d'une paroi ouverte adjacente.

Plus précisément, comme mieux illustré en figure 3B, les deux orifices 1040.1, 1041.1 ; 1040.2, 1041.2 ; 1040.3, 1041.3 de chaque paroi ouverte respectivement 104.1, 104.2, 104.3 sont réalisés en étant diamétralement opposés l'un à l'autre et chacun décalé angulairement d'un orifice d'une paroi adjacente d'un angle de 45° par rapport à l'axe longitudinal X.

La paroi 104.1 externe, c'est-à-dire la plus proche des orifices d'entrée 11 et de sortie 12, a un orifice 1040.1 agencé à proximité de l'orifice d'entrée 11 et l'autre 1041.1 est agencé à proximité de l'orifice de sortie 12.

Ainsi, grâce aux parois ouvertes 104.1, 104.2, 104.3, on forme des chicanes ou autrement dit un chemin tortueux pour les précurseurs gazeux à l'intérieur de la chambre de réaction 1.

Pour éviter toute inhomogénéité dans la couche déposée à la surface du substrat (wafer), on procède systématiquement de la manière suivante :
a/ positionnement du substrat sur la sole 100 de la chambre de réaction 10;
b/ obturation de l'orifice de sortie 12;
c/ injection d'un premier précurseur gazeux de la couche mince à travers l'orifice d'entrée 11;
d/ arrêt de l'injection ;
e/ ouverture de l'orifice de sortie 12 avec aspiration à travers celui-ci.

Dans le cadre de l'invention, le temps entre l'arrêt de l'injection selon l'étape d/ et l'ouverture selon l'étape e/ peut varier afin de laisser baigner le substrat (wafer) dans l'atmosphère de précurseurs. Typiquement, ce temps peut varier entre 0.1s et plusieurs dizaines de secondes. Puis, on réitère exactement les étapes b/ à e/ mais avec un deuxième précurseur de la couche mince pendant une deuxième durée.

Le positionnement du substrat (wafer) selon l'étape a/ peut avantageusement être réalisé en orientant vers le bas la surface du substrat sur laquelle on souhaite réaliser la couche mince : on peut ainsi faire reposer le substrat uniquement sur trois pions de supportage, typiquement équidistants et à 120° les uns des autres. Les pions de supportage sont de préférence de faible hauteur, typiquement à 5mm de la sole. Cela permet de réduire aussi, à la surface du substrat, les particules pouvant émaner du couvercle.

L'obturation de l'orifice de sortie 12 peut être réalisée directement ou indirectement par fermeture d'une vanne présente sur un conduit de pompage en aval relié à l'orifice de sortie. Typiquement, dans un réacteur ALD selon l'état de l'art cette vanne peut exister déjà. Par exemple, dans un réacteur commercialisé par la société Cambridge NanoTech sous la dénomination commerciale Savannah 200, cette vanne est dénommée « *Exposure Mode* ». Ainsi en obturant l'orifice de sortie 12, préalablement à l'injection d'un précurseur gazeux, l'ensemble de la chambre de réaction 10 ainsi que la partie du substrat apparente dans la chambre sont exposées au précurseur gazeux injecté mais son flux n'est pas perturbé car il n'y a pas d'écoulement à proprement parler tant que la vanne reste fermée. Autrement dit grâce aux chicanes formées par les parois ouvertes 104.1, 104.2, 104.3 on s'assure de créer un chemin tortueux pour le flux gazeux de précurseurs et également pour les particules qui ne peuvent donc être projetées directement à la surface du substrat et avec l'obturation de l'orifice de sortie 12 on réalise un dépôt homogène de la couche mince par diffusion des précurseurs gazeux.

L'azote N2 est le gaz porteur lorsqu'on ré-ouvre la vanne pour le pompage. L'azote N2 peut également servir finalement à purger l'ensemble.

Le réacteur ALD 1 qui vient d'être décrit peut être avantageusement utilisé pour l'encapsulation d'un substrat à OLED par une couche en Al₂O₃ à partir de vapeur d'eau et de triméthylaluminium (TMA).

D'autres variantes et améliorations peuvent être prévues sans pour autant sortir du cadre de l'invention.

Ainsi, bien que décrite plus précisément en référence au réacteur 1 avec l'orifice d'entrée 11 et l'orifice de sortie 12 formée sur la base 2, l'invention peut s'appliquer à toute géométrie de réacteur connue dans la mesure où les chicanes selon l'invention peuvent être implantées. D'ailleurs, on peut mettre en oeuvre l'invention sur des réacteurs ALD déjà existants, tel que celui commercialisé par la société Cambridge NanoTech sous la dénomination commerciale Savannah 200.

Bien que le réacteur 1 selon l'invention montré en figures 3A et 3B est réalisé avec un nombre de trois parois ouvertes 104.1, 104.2, 104.3 on peut bien entendu en réaliser un nombre plus important afin d'augmenter encore le trajet de circulation des précurseurs gazeux avant d'atteindre le substrat.

De même, si l'angle de décalage entre orifices de parois adjacentes est égal à 45° pour le réacteur 1 représenté en figures 3A et 3B, il va de soi que l'on peut avoir un nombre d'orifices et une valeur de décalage angulaire entre eux différentes.

Si les orifices des parois représentés sont de simples trous de section circulaire (voir trou 1040.2 en figure 3A), on peut également envisager des orifices sous forme de fente, par exemple de section rectangulaire.

L'invention peut être avantageusement appliquée pour toute encapsulation par couche atomique d'un substrat.

L'invention n'est pas limitée aux exemples qui viennent d'être décrits ; on peut notamment combiner entre elles des caractéristiques des exemples illustrés au sein de variantes non illustrées.

### REFERENCES CITEES

[1] : « Plasma particulate contamination control-I. Transport and process effects », de G. S. Selwyn Journal Vacuum Science Technology, pp 3487-3492, Journal Vacuum Science Technology B 9 (6), November/December1991 ;
[2] : « Plasma particulate contamination control. II. Self cleaning tool design », de G. S. Selwyn and E. F. Patterson pp 1053-1059 Journal Vacuum Science Technology. A, Vol. 10, No.4, July/August 1992.

## Revendications

1. Réacteur (1) pour le dépôt de couche atomique (ALD) comprenant :
- une chambre de réaction (10) comprenant une sole (100) adaptée pour supporter un substrat et étant délimitée intérieurement par une surface supérieure (101), une surface inférieure (102) et une surface latérale (103) entre la surface inférieure et la surface supérieure,
- au moins un orifice d'entrée (11) débouchant dans une des surfaces de délimitation de la chambre et par lequel au moins un précurseur gazeux peut être injecté directement dans la chambre de réaction ;
- au moins un orifice de sortie (12) débouchant dans une des surfaces de délimitation de la chambre et par lequel des espèces gazeuses ou des particules présentes dans la chambre de réaction peuvent être évacuées;
**caractérisé en ce que** la chambre de réaction comprend en outre en son sein, au moins une paroi ouverte (104.1, 104.2, 104.3) en au moins un orifice (1040.1, 1041.1 ; 1040.2, 1041.2 ; 1040.3, 1041.3), la paroi ouverte s'étendant autour de la sole et sur au moins une majeure partie de la hauteur entre la surface inférieure et la surface supérieure, au moins un orifice d'au moins une des parois ouvertes n'étant pas en regard de l'orifice d'entrée de sorte à former des chicanes de circulation de précurseur gazeux depuis chaque orifice d'entrée (11) jusqu'à la sole (100).

2. Réacteur selon la revendication 1, dans lequel la chambre de réaction comprend en son sein, une pluralité de parois ouvertes (104.1, 104.2, 104.3) chacune en au moins un orifice (1040.1, 1041.1 ; 1040.2, 1041.2 ; 1040.3, 1041.3), la pluralité de parois ouvertes s'étendant autour de la sole et sur au moins une majeure partie de la hauteur entre la surface inférieure et la surface supérieure, un orifice d'une paroi ouverte n'étant pas en regard d'un orifice d'une paroi ouverte adjacente de sorte à former des chicanes de circulation de précurseur gazeux depuis chaque orifice d'entrée (11) jusqu'à la sole (100).

3. Réacteur selon la revendication 1 ou 2, dans lequel l'orifice d'entrée et l'orifice de sortie sont formés dans la surface inférieure et disposés de part et d'autre du centre de la sole.

4. Réacteur selon la revendication 2 ou 3, dans lequel les parois sont de forme générale cylindrique et sont agencées autour de la sole de manière concentrique l'une par rapport à l'autre.

5. Réacteur selon la revendication 4, dans lequel chaque paroi ouverte est percée de deux orifices diamétralement opposés (1040.1, 1041.1 ; 1040.2, 1041.2 ; 1040.3, 1041.3), chaque orifice d'une paroi étant agencé angulairement à 90° d'un orifice d'une paroi ouverte adjacente par rapport à l'axe des cylindres.

6. Réacteur selon l'une des revendications précédentes, dans lequel le(s) orifice(s) de la (des) paroi(s) ouverte(s) est (sont) une (des) fente(s).

7. Réacteur selon l'une des revendications 1 à 5, dans lequel le(s) orifice(s) de la (des) paroi(s) ouverte(s) est (sont) un (des) trou(s) de section circulaire.

8. Réacteur selon l'une des revendications précédentes, dans lequel la paroi ouverte (104.1) la plus proche des orifices d'entrée (11) et de sortie (12) est ouverte en deux orifices dont l'un (1040.1) est agencé à proximité de l'orifice d'entrée et l'autre (1041.1) est agencé à proximité de l'orifice de sortie.

9. Procédé de réalisation d'une couche mince sur un substrat par dépôt de couche atomique (ALD), selon lequel on réalise les étapes suivantes :
a/ positionnement du substrat sur la sole d'une chambre de réaction délimitée intérieurement par une surface supérieure, une surface inférieure et une surface latérale entre la surface inférieure et la surface supérieure, ladite chambre comprenant en outre en son sein, une pluralité de parois ouvertes en au moins un orifice, la pluralité de parois ouvertes s'étendant autour de la sole et sur au moins une majeure partie de la hauteur entre la surface inférieure et la surface supérieure, un orifice d'une paroi ouverte n'étant pas en regard d'un orifice d'une paroi ouverte adjacente ;
b/ obturation de l'orifice de sortie débouchant dans une des surfaces de délimitation de la chambre et par lequel des espèces gazeuses ou des particules présentes dans la chambre de réaction peuvent être évacuées;
c/ injection d'un premier précurseur gazeux de la couche mince à travers un orifice d'entrée débouchant dans une des surfaces de délimitation de la chambre tout en maintenant l'orifice de sortie obturé pendant une première durée;
d/ arrêt de l'injection ;
e/ ouverture de l'orifice de sortie avec aspiration à travers celui-ci; les étapes b/à e/ étant réitérées mais avec un deuxième précurseur de la couche mince pendant une deuxième durée.

10. Procédé de réalisation d'une couche mince sur un substrat par dépôt de couche atomique (ALD) selon la revendication 9, selon lequel le positionnement du substrat selon l'étape a/ est réalisé en orientant vers le bas sa surface sur laquelle la couche mince est réalisée.

11. Procédé de réalisation d'une couche mince sur un substrat par dépôt de couche atomique (ALD) selon la revendication 9 ou 10, selon lequel les premier et deuxième précurseurs gazeux sont injectés par le même orifice d'entrée.

12. Procédé de réalisation d'une couche mince d'Al₂O₃ sur un substrat par dépôt de couche atomique (ALD) selon l'une des revendications 9 à 11, selon lequel le premier précurseur est le triméthylaluminium (TMA) et le deuxième précurseur est de la vapeur d'eau.

13. Application du procédé selon l'une quelconque des revendications 9 à 12 pour l'encapsulation de dispositif à diodes électroluminescentes organiques (OLED).
